# EUROPEAN PATENT APPLICATION

(11) **EP 3 598 574 A1**
(43) Date of publication of application: **22.01.2020**
(21) Application number: 18767939.4
(22) Date of filing: 09.03.2018
(51) Int. Cl.: H01Q 1/44, H01P 1/30, H01Q 19/10, H05K 7/20

(54) **HEAT-DISSIPATION MECHANISM AND WIRELESS COMMUNICATION DEVICE**

(30) Priority: 14.03.2017 JP 2017048693
(71) Applicant: NEC Corporation, Tokyo 108-8001 (JP)
(72) Inventor: KOSAKA Keishi, Tokyo 108-8001 (JP); TOYAO Hiroshi, Tokyo 108-8001 (JP)
(74) Representative: Vossius & Partner Patentanwälte Rechtsanwälte mbB
(86) International application number: PCT/JP2018/009249
(87) International publication number: WO 2018/168699

(57) **Abstract**

[Problem] To enable an increase in heat-dissipation performance while enabling suppression of an increase in device size.

[Solution] A heat-dissipation mechanism comprises an antenna reflector plate 1 formed with a reflector surface for reflecting electromagnetic waves, and one or a plurality of conductor fins 2 connected to the reflector plate 1 crosswise. The conductor fins 2 are provided with at least one slit portion 3 separating the conductor fins 2 in a direction crosswise to the reflector surface. The slit portion 3 is provided with at least one bridging conductor portion 4 connecting parts of the conductor fins 2 separated across the slit portion.

## Description

### Technical Field

The present invention relates to a heat-dissipation mechanism and a wireless communication device.

### Background Art

In order to cope with recent rapid increase in wireless communication volume, use of a multiple-input and multiple-output communication method (MIMO communication method) in which a plurality of antennas are simultaneously used, and beamforming using an array antenna including a plurality of antenna elements arranged at intervals has been spreading. In addition, the number of antennas built into a wireless communication device such as a mobile base station, the number of communication circuits connected to the antennas, and the number of baseband circuits have been increasing. With increase of the number of those circuits, the wireless communication device has been generating a higher amount of heat, and cooling of the circuits has been a major challenge.

As a technique for accelerating heat dissipation in the wireless communication device as described above, a device described in PTL 1 described below is known. PTL 1 describes a wireless communication device in which a radiator and a reflector plate of an antenna are integrally provided and heat-dissipation performance per volume is improved. The wireless communication device has a configuration in which a metal reflector plate occupying a relatively large area is utilized as a heat-dissipation path, thereby reducing thermal resistance, and heat is dissipated through a radiating fin connected to a back side of the reflector plate to the air.

### Citation List

### Patent Literature

[PTL 1] US Patent Application Publication No. 2013/0222201

### Summary of Invention

### Technical Problem

However, since the wireless communication device described in aforementioned PTL 1 dissipates heat mainly using the radiating fin provided on the back side of the reflector plate, when the wireless communication device is installed on a wall, a pillar, or the like, a large portion of the radiating fin is covered with the wall, the pillar, or the like, consequently, the wireless communication device may not ensure sufficient amount of air to contact the radiating fin, and the heat-dissipation performance may be limited. In addition, the radiating fin may increase a depth of the wireless communication device, which leads to a problem of expanding a size of the device.

The present invention has been made to solve the aforementioned problem, and the present invention provides a wireless communication device that can improve heat-dissipation performance while preventing a size of the device from expanding.

### Solution to Problem

A heat-dissipation mechanism according to a first aspect of the present invention includes an antenna reflector plate on which a reflector surface for reflecting an electromagnetic wave is formed and one or more conductor fins connected to the reflector plate crosswise, the conductor fin includes at least one slit portion that separates the conductor fin in a direction intersecting with the reflector surface, and each of the slit portion includes at least one bridging conductor portion that connects portions of the conductor fin, the portions being separated across the slit portion. A wireless communication device according to a second aspect of the present invention includes the heat-dissipation mechanism according to the first aspect and further includes one or more antennas disposed on the reflector surface and a transceiver circuit connected to the reflector plate and configured to transmit and receive a wireless signal via the antenna.

### Advantageous Effects of Invention

The present invention is able to provide a heat-dissipation mechanism that can improve heat-dissipation performance while preventing a size of a device from expanding, and a wireless communication device including the heat-dissipation mechanism.

### Brief Description of Drawings

[Fig. 1] Fig. 1 is a schematic perspective view illustrating a minimum configuration of a heat-dissipation mechanism according to the present invention;
[Fig. 2] Fig. 2 is a schematic perspective view of a wireless communication device according to a first example embodiment of the present invention;
[Fig. 3] Fig. 3 is an enlarged view of a region adjacent to an antenna element in Fig. 2;
[Fig. 4] Fig. 4 is a diagram for explaining flow of heat in the first example embodiment;
[Fig. 5] Fig. 5 is a schematic diagram illustrating a device configuration of the wireless communication device according to the first example embodiment, in which (A) illustrates an example, (B) illustrates another example, and (C) illustrates still another example;
[Fig. 6] Fig. 6 is a schematic cross sectional view illustrating a state in which electromagnetic waves are emitted from antenna elements in the wireless communication device according to the first example embodiment;
[Fig. 7] Fig. 7 is a front view of a first variation of the first example embodiment, in which a radiating fin is modified;
[Fig. 8] Fig. 8 is a front view of a second variation of the first example embodiment, in which the radiating fin is modified;
[Fig. 9] Fig. 9 is a front view of a third variation of the first example embodiment, in which the radiating fin is modified;
[Fig. 10] Fig. 10 is a front view of a fourth variation of the first example embodiment, in which the radiating fin is modified;
[Fig. 11] Fig. 11 is a front view of a fifth variation of the first example embodiment, in which the radiating fin is modified;
[Fig. 12] Fig. 12 is a front view of a sixth variation of the first example embodiment, in which a bridging conductor is modified;
[Fig. 13] Fig. 13 is a front view of a seventh variation of the first example embodiment, in which the bridging conductor is modified;
[Fig. 14] Fig. 14 is a front view of an eighth variation of the first example embodiment, in which the bridging conductor is modified;
[Fig. 15] Fig. 15 is a front view of a ninth variation of the first example embodiment, in which a plurality of slits are provided in the radiating fin;
[Fig. 16] Fig. 16 is a front view of a tenth variation of the first example embodiment, in which the radiating fin is utilized as a conductive layer for a dielectric;
[Fig. 17] Fig. 17 is a front view of an eleventh variation of the first example embodiment, in which the radiating fin is utilized as a conductive layer for a dielectric;
[Fig. 18] Fig. 18 is a front view of a twelfth variation of the first example embodiment, in which the radiating fin is extended;
[Fig. 19] Fig. 19 is a front view of a thirteenth variation of the first example embodiment, in which the radiating fin is extended;
[Fig. 20] Fig. 20 is a front view of a fourteenth variation of the first example embodiment, in which the radiating fin is extended;
[Fig. 21] Fig. 21 is a schematic perspective view of a wireless communication device according to a second example embodiment of the present invention;
[Fig. 22] Fig. 22 is a schematic perspective view of a first variation of a radome according to the second example embodiment;
[Fig. 23] Fig. 23 is a schematic perspective view of a second variation of the radome according to the second example embodiment;
[Fig. 24] Fig. 24 is a schematic perspective view of a third variation of the radome according to the second example embodiment;
[Fig. 25] Fig. 25 is a schematic perspective view of a fourth variation of the radome according to the second example embodiment;
[Fig. 26] Fig. 26 is a schematic perspective view of a wireless communication device according to a third example embodiment of the present invention;
[Fig. 27] Fig. 27 is a schematic perspective view of a region adjacent to an antenna element in Fig. 26;
[Fig. 28] Fig. 28 is a schematic perspective view of a first variation of the third example embodiment, in which a radome is provided;
[Fig. 29] Fig. 29 is a schematic perspective view of a second variation of the third example embodiment, in which antenna patterns are provided on front and back surfaces of a dielectric;
[Fig. 30] Fig. 30 is a schematic perspective view of an antenna pattern of a third variation of the third example embodiment;
[Fig. 31] Fig. 31 is a schematic view of an antenna circuit of the third variation of the third example embodiment;
[Fig. 32] Fig. 32 is a schematic perspective view of a fourth variation of the third example embodiment;
[Fig. 33] Fig. 33 is a schematic perspective view of a wireless communication device according to a fourth example embodiment;
[Fig. 34] Fig. 34 is a schematic plan view of the fourth example embodiment;
[Fig. 35] Fig. 35 is a schematic plan view of a wireless communication device according to a fifth example embodiment of the present invention;
[Fig. 36] Fig. 36 is a schematic plan view of a first variation of the fifth example embodiment; and
[Fig. 37] Fig. 37 is a schematic perspective view of a second variation of the fifth example embodiment.

### Example Embodiment

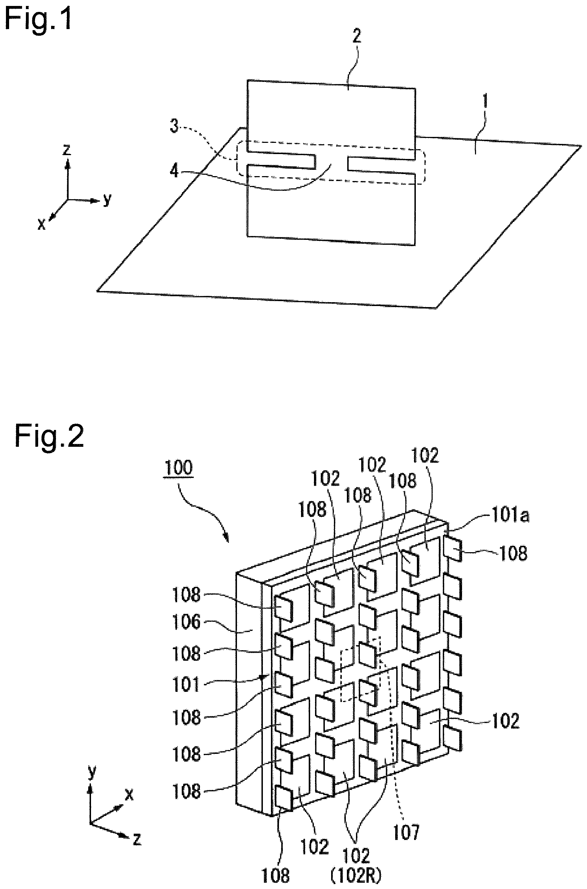

Fig. 1 illustrates an example of a minimum configuration of a heat-dissipation mechanism according to the present invention, and a sign 1 represents a reflector plate on which a reflector surface for reflecting an electromagnetic wave is formed. The reflector plate 1 includes at least one conductor fin 2 connected to the reflector plate 1 in a direction intersecting with (in the figure, a direction generally perpendicular to) the reflector plate 1. The conductor fin 2 includes at least one slit portion 3 that separates the conductor fin 2 in a direction intersecting with the reflector surface of the reflector plate 1, i.e., along a face of the conductor fin 2.

In addition, the slit portion 3 includes at least one bridging conductor portion 4 that connects portions of the conductor fin 2, which portions are separated across the slit portion 3.

The aforementioned configuration enables heat conducting from the reflector plate 1 to radiate from the conductor fin 2 to the atmosphere or the like. Since the conductor fin 2 has the slit portion 3 formed in a direction generally perpendicular to the reflector surface, the conductor fin 2 has a characteristic of transmitting a radio wave having an electric field in a direction perpendicular to the reflector plate; consequently, the conductor fin 2 can reduce an effect that the conductor fin 2 has on reflective performance of an antenna element against electromagnetic waves. In addition, since the conductor fin 2 split by the slit portion 3 is linked by the bridging conductor portion 4, the conductor fin 2 can ensure heat conduction from a proximal end to a distal end of the conductor fin 2 and achieve a cooling effect.

### [First example embodiment]

A wireless communication device 100 according to a first example embodiment of the present invention will be described with reference to the drawings.

As illustrated in Fig. 2, the wireless communication device 100 according to the present example embodiment includes a box-shaped enclosure unit 106, a reflector plate 101 integrally attached to one side of the enclosure unit 106, an array antenna 102R including a plurality of antenna elements 102 provided on the reflector plate 101, one or more radiating fins 108 standing on the reflector plate 1 (in other words, connected to the reflector plate 101 generally perpendicularly), and a communication circuit 107 built into the enclosure unit 106.

The communication circuit 107 is electrically connected to the array antenna 102R. Accordingly, a wireless signal generated by the communication circuit 107 is emitted to the air via the array antenna 102R as an electromagnetic wave and sent to or received from another device (e.g. a wireless terminal or the like).

The communication circuit 107 is connected with the reflector plate 101 with a highly heat-conducting member interposed between them, and a portion of heat generated therein conducts to the reflector plate 101. As such a highly heat-conducting member, a ball grid array (BGA), a solder ball, or a member having a heat-conducting underfill filled around a solder ball may be used.

The reflector plate 101 is a plate-shaped member formed of an electrically conductive material. One side of the reflector plate 101 serves as a reflector surface 101 a for reflecting an electromagnetic wave. The reflector plate 101 is attached in such a way that the reflector surface 101a is disposed opposite to a contacting face of the reflector plate in contact with the enclosure unit 106. In the following description, directions orthogonal to each other in a plane in which the reflector surface 101a extends are defined as an x-axis direction and a y-axis direction, and a normal direction with respect to the x-y plane formed by the x-axis and the y-axis is defined as a z-axis direction. Hereinafter, the positive direction of the y-axis will be referred to as vertically upper or vertically upward and the negative direction of the y-axis will be referred to as vertically lower or vertically downward.

On the reflector surface 101 a, a plurality of the antenna elements 102 spaced apart from each other are arranged and form the array antenna 102R. In the present example embodiment, a plurality of the antenna elements 102 are arranged in a grid pattern (in the illustrated example, four rows by four columns) when viewed from the normal direction (z-axis direction) with respect to the reflector surface 101a. By varying a phase and/or an electric power of a signal for each antenna element 102 constituting the array antenna 102R, it is possible to achieve beamforming in which a radio wave may be intensively emitted in a specific direction.

In the present example embodiment, each of the antenna elements 102 is a planar patch antenna extending on a plane parallel to the reflector surface 101a. As the patch antenna, a publicly known type may be used, and by providing a feeding point penetrating through the reflector plate 101, for example, the patch antenna and the communication circuit 107 can be connected via the feeding point.

Between the antenna elements 102 and on both outer ends of the antenna elements 102 in each row are formed the radiating fins 108. In Fig. 2, the radiating fins 108 are standing on the reflector surface 101a and extends in a direction intersecting with (in the illustrated example, a direction generally orthogonal to) the reflector surface 101a. In addition, the radiating fins 108 are arranged in a matrix on the reflector surface 101a and disposed with the faces oriented in the same direction (aligned on the same plane or planes parallel to each other).

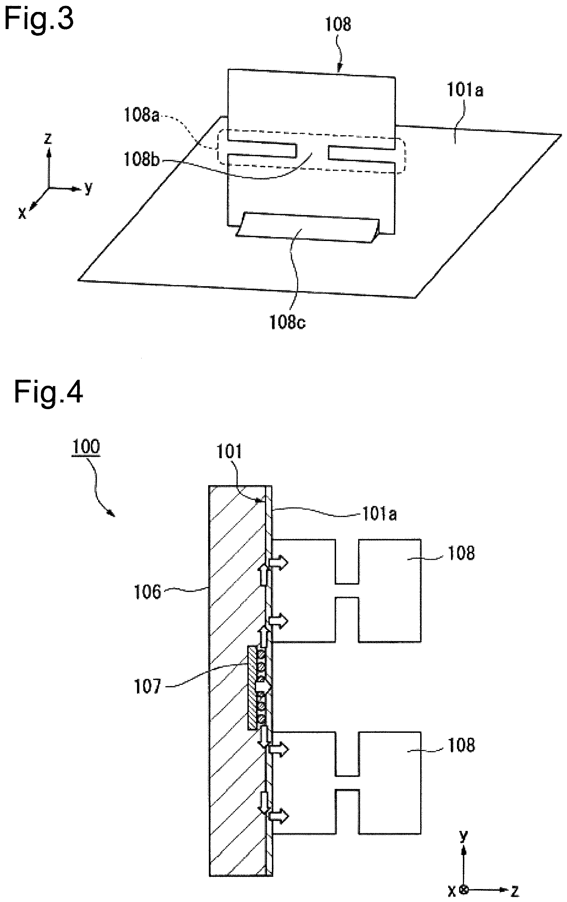

An example of a detailed structure of the radiating fin 108 is illustrated in Fig. 3. In Fig. 3, the radiating fin 108 is formed of a plate-shaped electrical conductor, and the plate-shaped electrical conductor is provided with a slit 108a that separates the plate-shaped conductor in a direction generally perpendicular to the reflector surface 101a and that is generally parallel to the reflector surface 101a and a bridging conductor 108b that electrically connects portions of the conductor facing against each other across the slit 108a. In addition, the radiating fin 108 is fixed, as illustrated in Fig. 3, on the reflector plate 101 by means of solder (connection) 108c or the like.

As a method for forming the radiating fin 108, various methods may be used. For example, the radiating fin 108 may be formed by sheet-metal processing; alternatively, it may be formed by machining a metal and integrally formed with the reflector plate 101 without using solder 108c or the like; or it may be formed as a conductor pattern on a plate-shaped dielectric. A method for forming the conductor pattern on a dielectric includes patterning metallic foil such as copper foil. The patterning process is common in manufacturing process of printed circuit boards or the like, and fine patterns may be formed through the patterning process. Conductors used for such patterns are composed of metal such as copper, silver, aluminum, or nickel, or other good conductor materials.

The dielectric may be a printed circuit board using, for example, a glass epoxy resin. Alternatively, the dielectric may be an interposer substrate of a large-scale integration (LSI), a module substrate using a ceramic material such as low temperature co-fired ceramic (LTCC), or a semiconductor substrate made of silicon or the like.

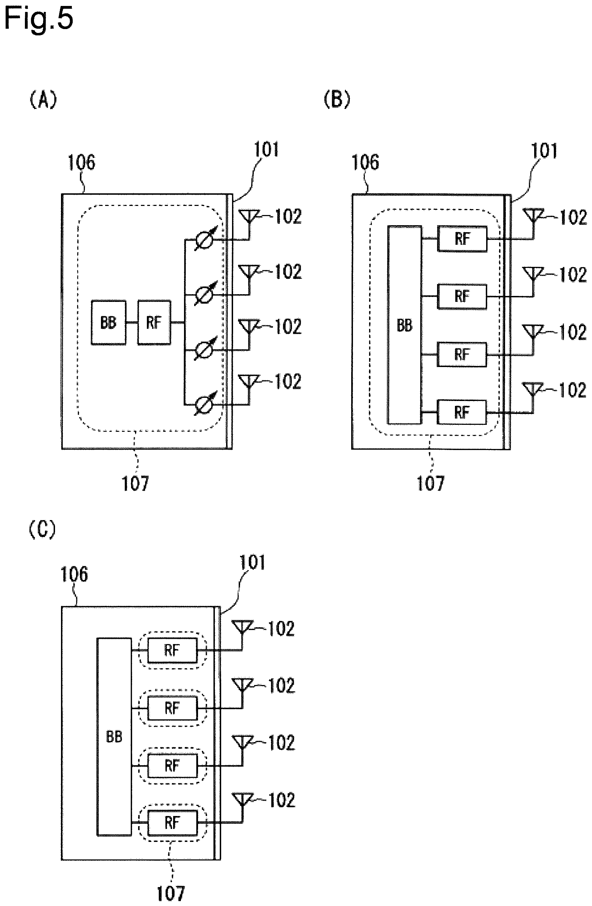

Fig. 5 (A) is a diagram schematically illustrating an example of a device configuration of the wireless communication device 100. In the wireless communication device 100 in Fig. 5 (A), a single communication circuit 107 is composed of a phase shifter, a radio frequency circuit (RF), and a baseband circuit (BB). Note that one phase shifter is included for each antenna element 102. With this configuration, a phase can be changed for each antenna element 102; consequently, a beam direction may be controlled.

Fig. 5 (B) illustrates another example of the device configuration of the wireless communication device 100. In the wireless communication device 100 in Fig. 5 (B), a single communication circuit 107 is composed of a radio frequency circuit (RF) and a baseband circuit (BB). Note that one radio frequency circuit is included for each antenna element 102.

With this configuration, the wireless communication device 100 can support spatially multiplexed communication in which each antenna element 102 transmits and receives a different wireless signal.

Fig. 5 (C) illustrates still another example of the device configuration of the wireless communication device 100. In the wireless communication device 100 in Fig. 5 (C), each of a plurality of communication circuits 107 is composed of a radio frequency circuit (RF). In other words, one communication circuit 107 is included for each antenna element 102.

With this configuration, the wireless communication device 100 can support spatially multiplexed communication in which each antenna element 102 transmits and receives a different wireless signal.

Note that the device configuration of the wireless communication device 100 is not necessarily limited to examples in Fig. 5 (A), Fig. 5 (B), and Fig. 5 (C). For example, in Fig. 5 (A) and Fig. 5 (B), the communication circuit 107 may have a configuration in which a baseband circuit (BB) is not included. In addition, the communication circuit 107 may have a configuration in which the baseband circuit (BB) is disposed outside the wireless communication device 100 or other configurations.

Next, an effect of the aforementioned wireless communication device 100 according to the first example embodiment will be described.

Fig. 4 is a schematic diagram illustrating flow of heat dissipation in the wireless communication device 100 according to the first example embodiment. Fig. 4 illustrates a section of the wireless communication device 100 viewed from the negative direction of the x-axis. As illustrated in Fig. 4, heat generated in the communication circuit 107 conducts, as indicated by outlined arrows in the figure, through the reflector plate 101 to the radiating fins 108, which are electrical conductors, and is dissipated. Since the radiating fin includes an electrical conductor, heat conductivity thereof is high; therefore, heat generated in the communication circuit 107 is efficiently dissipated. Because the wireless communication device 100 includes the radiating fin 108, an area in which the heat generated in the wireless communication device 100 contacts air, in other words, a heat-dissipating area increases. Therefore, heat-dissipation performance of the wireless communication device 100 improves.

The direction in which the radiating fin 108 extends preferably coincides with the y-axis direction as illustrated in Fig. 2. The air heated by heat dissipated from the radiating fin 108 gains a force directed in a vertically upward direction as density of the heated air decreases. Therefore, since the radiating fins 108 are arranged in the y-axis direction, natural convection of air directed from a vertically lower side to a vertically upper side is not disturbed, and heat may be efficiently dissipated. Note that the direction in which the radiating fins 108 extend is not limited to the y-axis direction, and it may be any direction in the x-y plane. In addition, positions of the radiating fins 108 on the reflector surface 101a are not limited by the arrangement illustrated in Fig. 2. For example, in Fig. 2, the radiating fins 108 are disposed between antenna elements 102 arranged in the x-axis direction; however, the radiating fins 108 may be disposed between antenna elements 102 arranged in the y-axis direction.

Note that, when the radiating fin 108 is composed of an electrical conductor and connected to the reflector plate by solder 108c or the like, the radiating fin 108 has an effect that is electrically substantially identical with the effect of a configuration in which part of the conductor of the reflector plate near the antenna projects in the positive direction of the z-axis. In other words, this structure disturbs an electromagnetic field near the antenna and an electromagnetic wave to be emitted; consequently, an operation of the antenna element is disturbed. Therefore, in the present invention, considering that the electric field generated by the antenna element and immediately above the reflector plate 101 is perpendicular to the reflector plate 101, in order to separate the conductor in a direction perpendicular to the reflector plate, the radiating fin 108 includes the slit 108a illustrated in Fig. 3. Since the radiating fin 108 partially separated by the slit 108a has a characteristic that an electromagnetic wave having an electric field in a direction parallel to the direction of separation (z-axis direction) may be transmitted, the radiating fin 108 including the slit 108a has a characteristic that a radio wave having an electric field in a direction perpendicular to the reflector plate may be transmitted; as a result, the effect that the radiating fin 108 has on the antenna element may be reduced. The radiating fin 108 further includes, in order to efficiently conduct heat from the reflector plate to the distal end thereof, a bridging conductor 108b across the slit. In this case, a radio wave transmission characteristic of the radiating fin 108 varies according to a frequency of an electromagnetic wave, and a frequency characteristic is determined by a capacitance between conductors facing across the slit 108a and an inductance of the bridging conductor 108b; therefore, the radiating fin 108 is desirably designed in such a way that the radiating fin 108 has an optimum transmission characteristic for a resonance frequency of the antenna elements by adjusting the design, i.e., dimensions and shapes, of the slit 108a and the bridging conductor 108b.

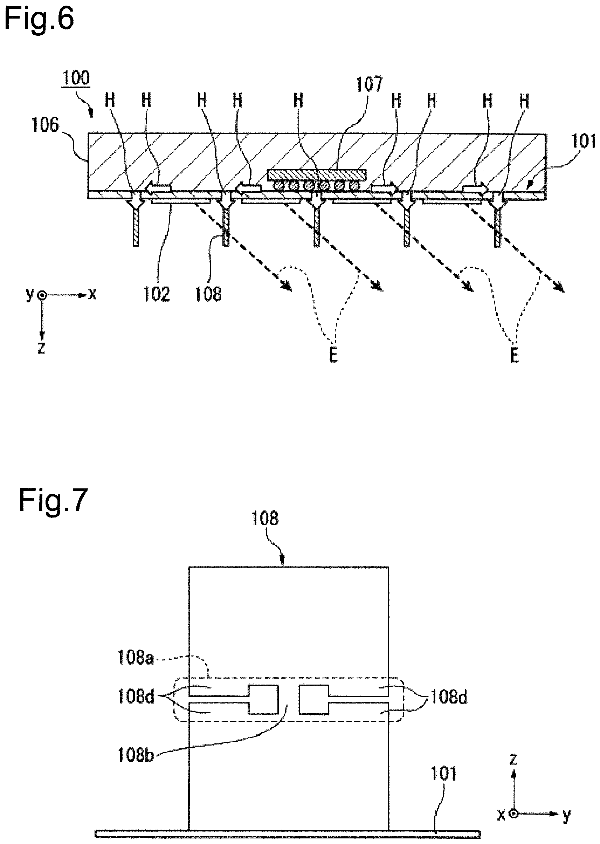

Fig. 6 is a schematic cross sectional view illustrating a state in which electromagnetic waves E are emitted, as indicated by dashed-line arrows in the figure, from the antenna elements 102 in the wireless communication device 100 according to the first example embodiment. The electromagnetic waves E emitted from the antenna elements 102 are emitted, in order to achieve beamforming, with orientations in various directions. Therefore, the electromagnetic waves E emitted in the direction indicated by the dashed-line arrows at a predetermined angle with respect to the z-axis direction enter the radiating fins 108. Since the radiating fins 108 have a radio wave transmission characteristic, the electromagnetic waves E emitted from the antenna elements 102 can pass through the radiating fins 108. In this manner, since the radiating fins 108 transmit the electromagnetic waves E, the wireless communication device 100 can perform wireless communication with other devices without limiting a radiation angle of the electromagnetic waves E.

As described above, the wireless communication device 100 according to the first example embodiment of the present invention can improve, using the radiating fin 108, the performance of dissipating the heat generated in the communication circuit 107. When the communication circuit 107 generates heat upon transmitting and receiving wireless signals, the heat may have an effect on operations of the communication circuit 107 or other circuits not illustrated. In other words, the heat generated in the communication circuit 107 thermally conducts along a conduction path H indicated by outlined arrows in the figure, and by dissipating the heat from the radiating fin 108, the heat-dissipation performance improves; thus, the wireless communication device 100 may be stably operated.

In addition, in the wireless communication device 100 according to the first example embodiment of the present invention, the radiating fin 108 can transmit the electromagnetic wave emitted from the antenna element 102. Therefore, the wireless communication device 100 can prevent the radiating fin 108 from interfering with wireless communication using the antenna elements 102.

The wireless communication device according to the first example embodiment of the present invention has been described above with reference to the drawings; however, various changes may be made to the configuration described above without departing from the gist of the present invention.

For example, in the present example embodiment, the communication circuit 107 is built into the enclosure unit 106; as a result, the communication circuit 107 is disposed on a side opposite to the reflector surface 101a of the reflector plate 101. However, as long as the communication circuit 107 can conduct heat to the reflector plate 101, the communication circuit 107 may be freely disposed. In addition, if the communication circuit 107 and the reflector plate 101 are connected via a highly heat-conducting material, the communication circuit 107 may not be necessarily connected directly to the reflector plate 101. Furthermore, the communication circuit 107 may be disposed on a side of the reflector surface 101a of the reflector plate 101 or disposed at other positions.

Although, in Fig. 2, the wireless communication device 100 includes the array antenna 102R including a plurality of the antenna elements 102 and a plurality of the radiating fins 108, the wireless communication device 100 may not necessarily include a plurality of the antenna elements 102 and a plurality of the radiating fins 108; the wireless communication device 100 may include only one antenna element 102 and only one radiating fin 108.

In addition, the radiating fin 108 may not necessarily have the structure illustrated in Fig. 2.

For example, as illustrated as a first variation in Fig. 7, the radiating fin 108 may include, in a region distant from the bridging conductor 108b at an end of the conductors separated across the slit 108a, an additional conductor portion 108d that shortens a distance between the conductors separated across the slit 108a. With the additional conductor portion 108d, the capacitance between the conductors separated by the slit 108a may be increased without changing the inductance of the bridging conductor 108b.

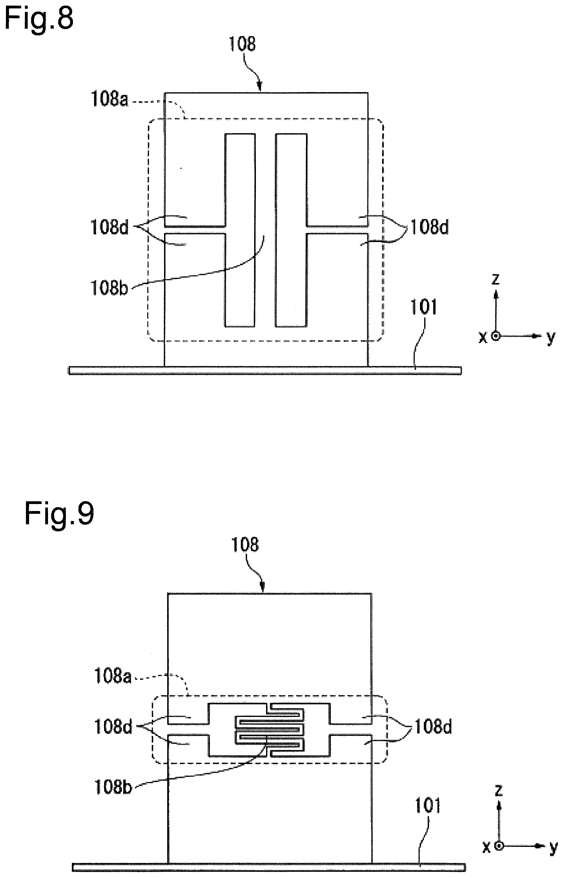

Furthermore, in the radiating fin 108, as illustrated as a second variation in Fig. 8, the slit 108a may be extended in the direction generally perpendicular to the reflector surface 101a. In this manner, the inductance of the bridging conductor 108b may be increased. In addition to this, with the additional conductor portion 108d, the capacitance between the conductors separated by the slit 108a may be kept or increased. In addition, as illustrated as a third variation in Fig. 9, the inductance may be increased by forming the bridging conductor 108b in a meandering shape.

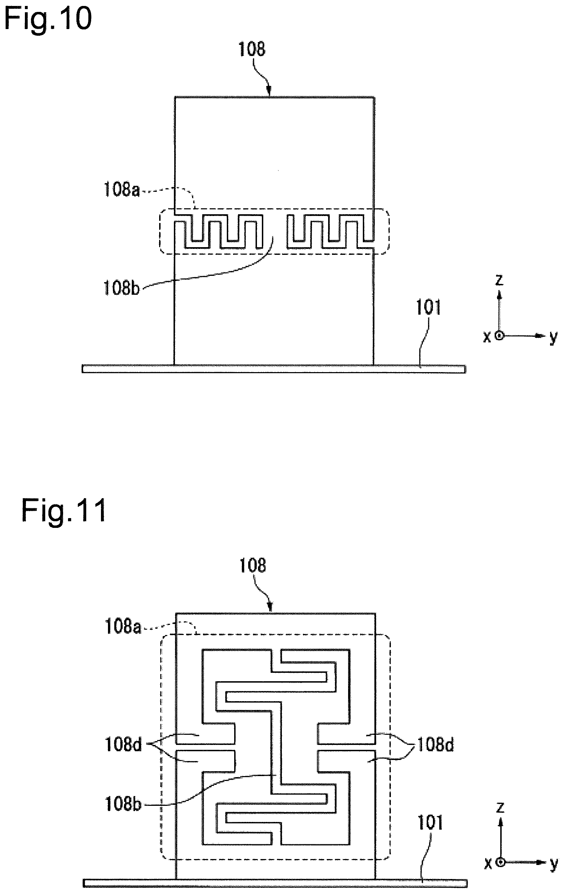

As illustrated as a fourth variation in Fig. 10, the slit 108a may be a slit having a meandering shape. In this manner, the capacitance between the conductors separated across the slit 108a may be increased. Furthermore, as illustrated as a fifth variation in Fig. 11, when the slit 108a is extended, similarly to the one in Fig. 8, in the direction generally perpendicular to the reflector surface 101a, a portion of the additional conductor portion 108d, which is closer to the other additional conductor portion 108d facing across the slit 108a, may be extended in the y-axis direction. In this manner, in Fig. 11, utilizing a space in which the additional conductor portion 108d is not extended in the y-axis direction, the bridging conductor 108b may have a meandering shape. Therefore, without reducing the capacitance between the conductors separated across the slit 108a, the inductance of the bridging conductor 108b may be increased.

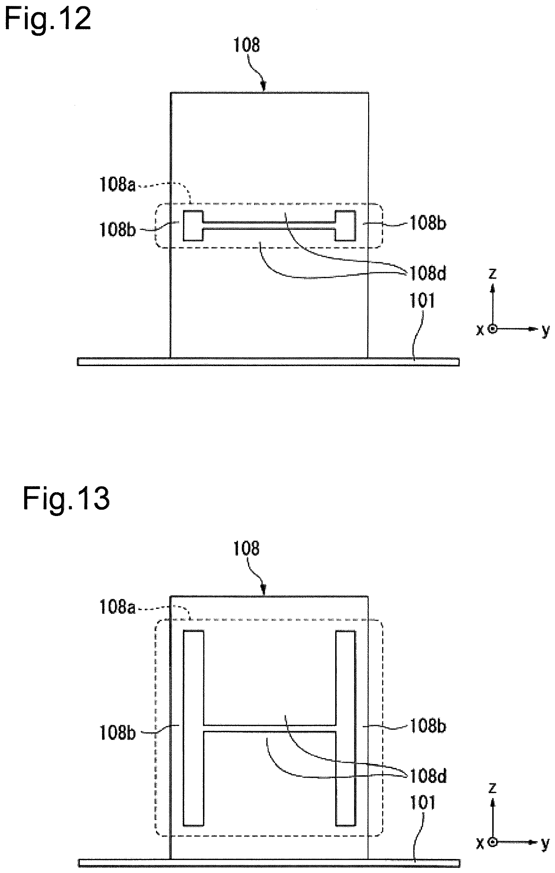

Although, in Fig. 3, a single bridging conductor 108b is positioned approximately at the center of the slit 108a, as illustrated as sixth and seventh variations in Fig. 12 and Fig. 13, respectively, the radiating fin 108a may include a plurality of bridging conductors 108b, and a plurality of the bridging conductors 108b may be positioned at positions other than the center of the slit 108a, for example, at ends in the y-axis direction in the figure.

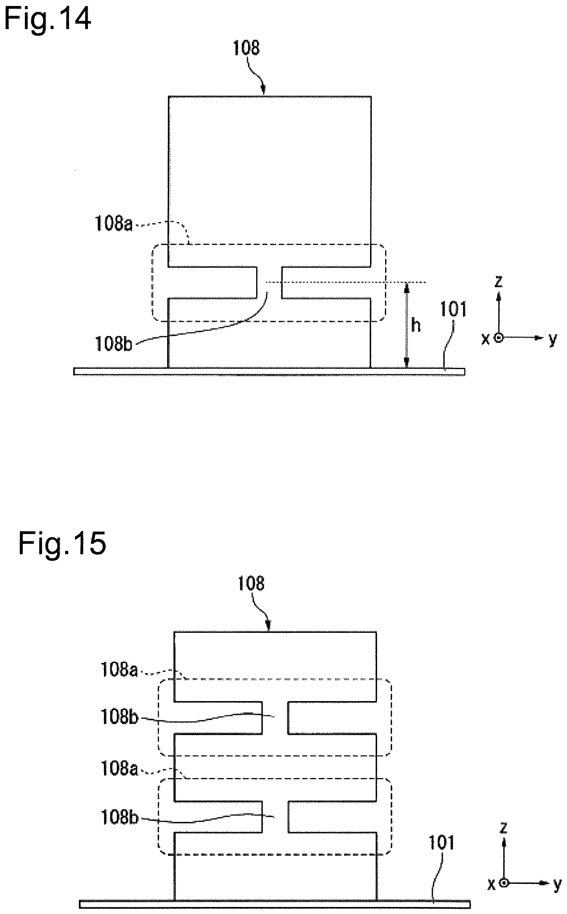

In addition, although, in Fig. 3, the slit 108a is positioned at the center of the radiating fin 108 in the z-axis direction, as illustrated as an eighth variation in Fig. 14, the slit 108a may be positioned at positions other than the center of the radiating fin 108 in the z-axis direction. However, if a distance h illustrated in Fig. 14 between the center of the slit 108a and the reflector surface 101a is too long, a conductor portion connected to the reflector plate 101 and projecting in the positive direction of the z-axis direction becomes too long; consequently, the performance of the antenna element 102 will be more likely to be adversely affected.

Therefore, when a wavelength of the electromagnetic wave emitted by the antenna element 102 in vacuum is λ, the distance h is desirably λ/4 or less. However, due to degradation in the heat-transfer characteristic of the slit 108a, the amount of heat conducted in the positive direction of the z-axis from the slit 108a to the radiating fin 108 decreases due to degradation in the heat-transfer characteristic of the slit 108a; therefore, if the distance h is too short, the amount of heat conducted to the entire radiating fin 108 decreases and the heat-dissipation performance will be deteriorated. Therefore, as long as the deterioration in the performance of the antenna element 102 is within an allowable range, the distance h is desirably as long as possible.

In addition, since the radio wave transmission characteristic of the radiating fin 108a improves as the number of the slits 108a is greater, the radiating fin 108 may include, as illustrated as a ninth variation in Fig. 15, a plurality of slits 108a.

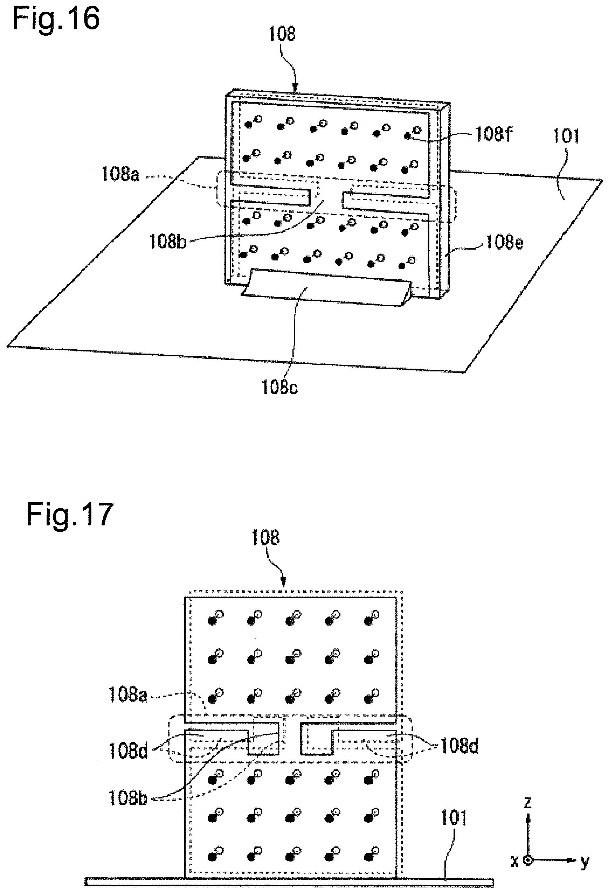

In addition, as illustrated as a tenth variation in Fig. 16, the radiating fin 108 may be formed as a plurality of conductor layers in a dielectric substrate 108e. In Fig. 16, although the radiating fin 108 includes a two-layered conductor pattern, the radiating fin 108 may include, not limited to two layers, three layers of conductor patterns. In this case, a plurality of the conductor layers may be electrically connected by a conductor via 108f. By connecting the conductors constituting the radiating fin 108 by the conductor via 108f more tightly, the heat conductivity of the radiating fin 108 can be improved. While the conductor via 108f are commonly formed by forming a through-hole by drilling the dielectric substrate 108e and plating the through-hole, as long as the layers are electrically connected, anything may be used. For example, a laser via formed by laser may be used, or a copper wire or the like may be used. Alternatively, as illustrated as an eleventh variation in Fig. 17, the additional conductor portions 108d may be provided in different conductor layers in such a way as to face each other. In this manner, the capacitance between the conductors separated across the slit 108a may be more increased.

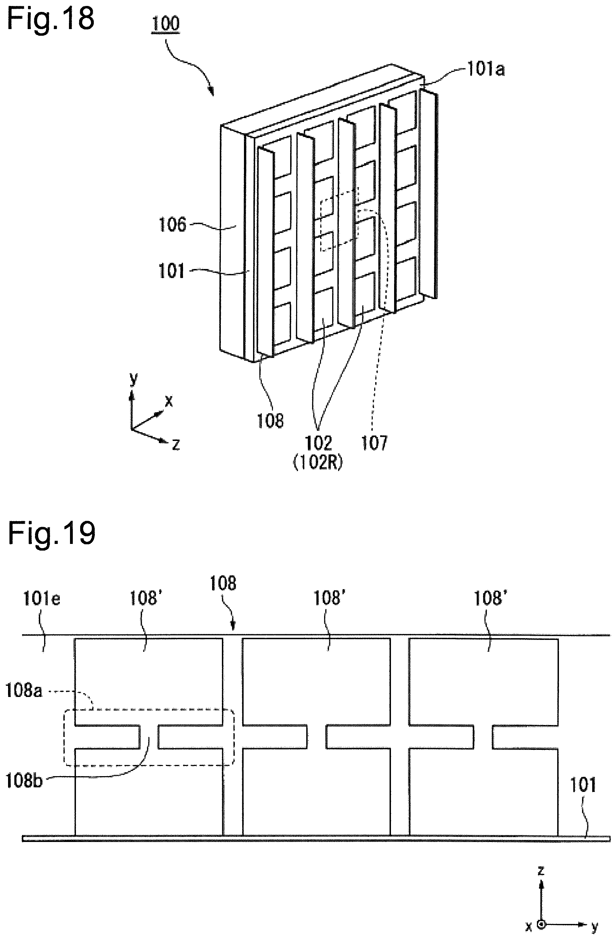

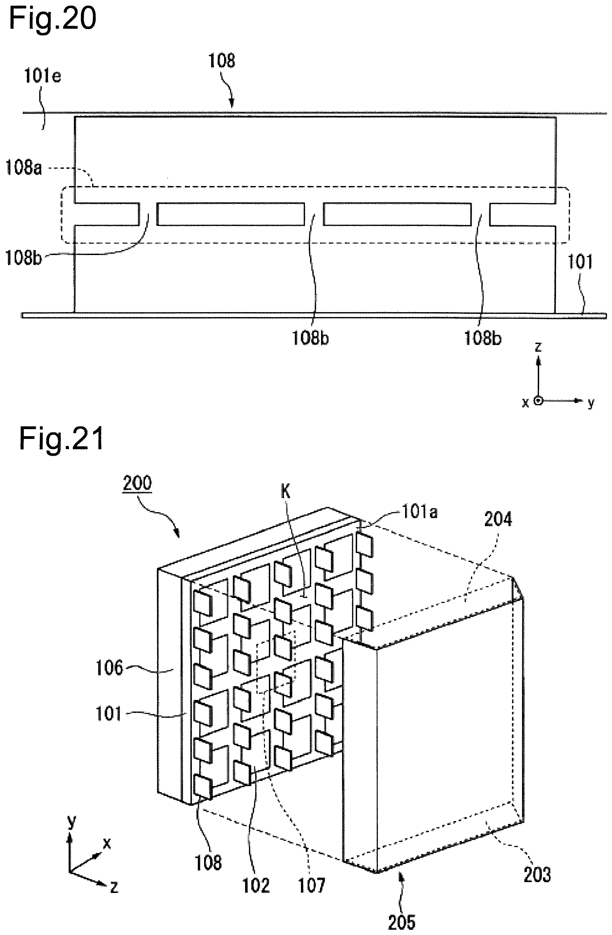

Furthermore, as illustrated as a twelfth variation in Fig. 18, the radiating fin 108 may be extended in the y-axis direction and form a shape continuous on the same plane. In this case, an ascending airflow formed by the heat dissipated from the radiating fin 108 in the positive direction of the y-axis around the radiating fin is efficiently rectified, and the heat-dissipation performance improves. In this case, the radiating fin 108 may have a structure, as illustrated as a thirteenth variation in Fig. 19, in which a plurality of conductor patterns of the radiating fin 108 described above are arranged at intervals in the y-axis direction on the dielectric substrate 108e extended in the y-axis direction. Alternatively, as illustrated as a fourteenth variation in Fig. 20, a single conductor pattern of the radiating fin 108 described above may be extended in the y-axis direction and disposed on the dielectric substrate 108e extended in the y-axis direction. In Fig. 20, a plurality of bridging conductors 108b are provided at approximately equal intervals in the slit 108a. Note that, while a width of the conductor pattern of the radiating fin 108 in the y-axis direction may be extended as illustrated in Fig. 20, the conductor pattern is desirably configured not to interfere with the electromagnetic wave emitted by the antenna and the width is desirably λ/2 or less.

Furthermore, on a surface of the radiating fin 108, an electrically non-conductive protective film may be provided. Such a configuration can protect the radiating fin 108 from rain or snow outside or dust, and weather resistance of the wireless communication device 100 can be improved. The protective film is preferably water-repellent or water-resistant; however, needless to say, it may have other properties.

### [Second example embodiment]

Fig. 21 is a schematic perspective view of a wireless communication device 200 according to a second example embodiment of the present invention. The wireless communication device 200 according to the second example embodiment is different from the wireless communication device 100 according to the first example embodiment in that a radome 205 is provided. The same reference signs denote the components similar to those in the wireless communication device 100 according to the first example embodiment, and the detailed description thereof is not repeated. In Fig. 21, in order to facilitate understanding, the reflector plate 101 and the radome 205 are illustrated in a state in which they are detached from the assembled state.

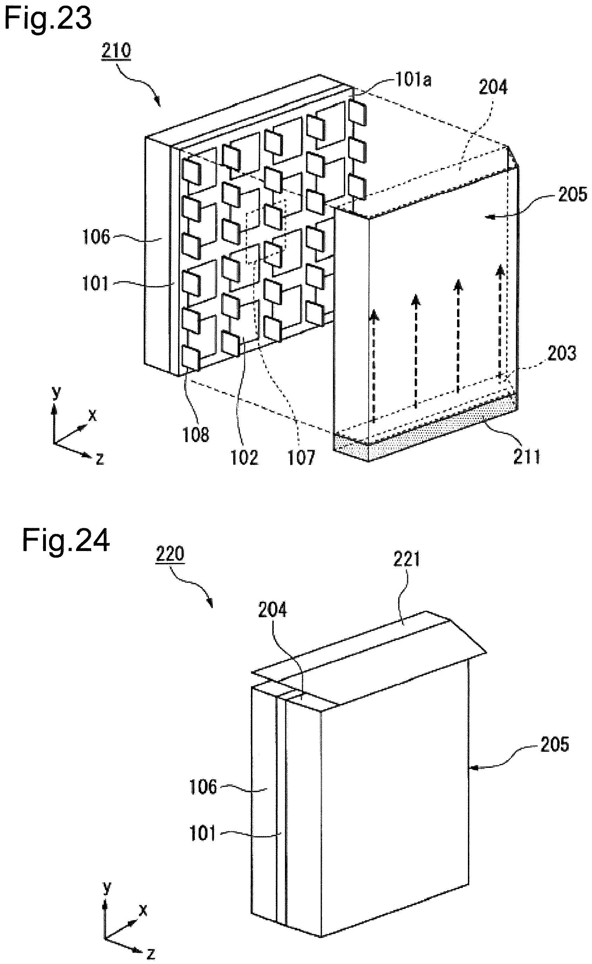

The radome 205 has a planar shape that is generally the same as that of the reflector surface 101a of the reflector plate 101, and it is a member that covers the entire reflector surface 101a. The radome 205 is C-shaped in a plan view (viewed from above in Fig. 23), and has openings on vertically upper and vertically lower faces. In other words, in the wireless communication device 200 according to the second example embodiment, an airflow path K surrounded by the radome 205 and the reflector plate 101 is formed. The airflow path K accommodates a plurality of the antenna elements 102 provided on the reflector surface 101a. Since the radome 205 covers the antenna elements 102 and the like, the wireless communication device 200 can protect the antenna elements 102 from physical impact.

Although the illustrated radome 205 has a shape including a corner, as long as the radome 205 can cover the reflector surface 101a, the shape of the radome 205 is not particularly limited. For example, the radome may have a shape including a curved face that covers the reflector surface 101a.

The radome 205 is typically made of a dielectric material. When the radome 205 is made of a dielectric material, the radome 205 can transmit the electromagnetic waves emitted by the antenna elements 102 accommodated in the airflow path K.

Note that the radome 205 may be composed of, instead of the dielectric material, a frequency selective sheet (FSS). The frequency selective sheet typically has a structure in which conductor patterns such as a conductor strip or an opening of a conductor plate are periodically arranged, and depending on a design of the conductor patterns, the frequency selective sheet can selectively transmit or reflect an electromagnetic wave in a specific frequency band among electromagnetic waves entering the frequency selective sheet. With the radome 205 composed of a frequency selective sheet that transmits an electromagnetic wave having a frequency emitted by the antenna elements 102, the radome 205 can transmit the electromagnetic waves emitted by the antenna elements 102. At the same time, the radome 205 includes a conductor; consequently, heat conductivity of the radome 205 improves. In this case, by connecting the radome 205 and the reflector plate 101 while securing the heat-transfer performance, the heat from the communication circuit 107 conducts to the radome 205; as a result, heat-dissipation performance of the wireless communication device 200 can be more improved.

In Fig. 21, the radome 205 has openings on vertically upper and vertically lower faces. The air heated by heat dissipation travels in a vertically upward direction as density of the air decreases. Therefore, the opening on the vertically lower side of the radome 205 is an air inlet 203 while the opening on the vertically upper side is an air outlet 204.

In the airflow path K formed by the radome 205, air flows due to natural convection. The heated air flows due to natural convection from the air inlet 203 side to the air outlet 204 side.

When the air in the airflow path K flows from the air inlet 203 side to the air outlet 204 side, air density on the air inlet 203 side decreases and air is supplied from outside. In other words, by providing the radome 205, continuous natural convection (so-called stack effect) occurs from the air inlet 203 toward the air outlet 204. As a result, fresh outside air is constantly supplied to the reflector surface 101a of the reflector plate 101 and a surface of the radiating fin 108, to which the heat generated in the communication circuit 107 is conducted; consequently, the heat-dissipation efficiency of the wireless communication device 200 further improves.

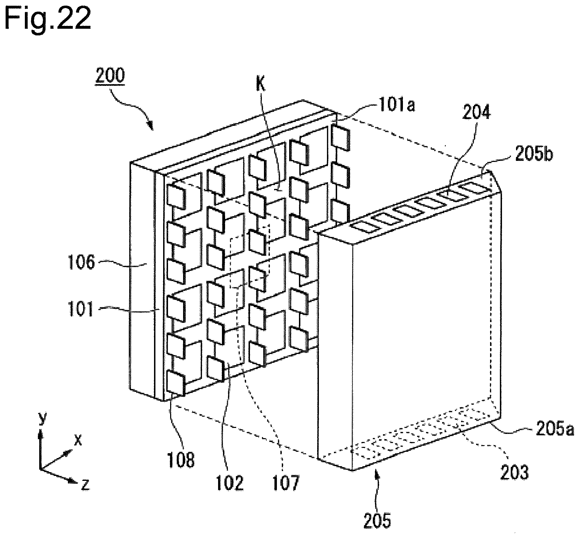

Fig. 21 illustrates, as examples of the air inlet 203 and the air outlet 204, openings of the radome 205 formed by removing the entire areas of the vertically lower face and the vertically upper face. However, the openings of the air inlet 203 and the air outlet 204 need not be formed by removing an entire area of a face. For example, as illustrated as a first variation in Fig. 22, the air inlet 203 and the air outlet 204 may be openings located in a region of a bottom plate 205a and a top plate 205b that respectively constitute the vertically lower face and the vertically upper face of the radome 205. In the present example embodiment, the radome 205 is assumed to have openings (the air outlet 204 and the air inlet 203) in each of the vertically upper face and the vertically lower face. However, as long as the wireless communication device 200 can introduce wind into the radome 205, positions and the number of the openings are not limited to this.

For example, the radome 205 may include the air inlet 203 and the air outlet 204 in faces other than the vertically upper face and the vertically lower face (i.e., side faces of the radome 205), or the radome 205 may include the air inlet 203 and the air outlet 204 in any of the vertically upper face, the vertically lower face, or the side faces. In addition, the radome 205 may include one opening in which the air inlet 203 and the air outlet 204 are integrally formed, or the radome 205 may include one or more air inlets 203 and one or more air outlets 204. An example in which the radome 205 includes a plurality of the air inlets 203 and a plurality of the air outlets 204 includes a configuration in which the radome 205 has openings in the vertically upper face and the vertically lower face and the side faces. When the wireless communication device 200 having this configuration is located outside, natural wind from outside is introduced into the radome 205; consequently, the heat-dissipation efficiency of the wireless communication device 200 further improves.

Furthermore, the airflow in the airflow path is not limited to natural convection. For example, as illustrated as a second variation in Fig. 23, the wireless communication device 210 may be provided with a fan 211 on the air inlet 203 side. Driven by externally supplied electric power, the fan 211 introduces air from outside into the airflow path. In this manner, as indicated by dashed-line arrows in the figure, forced convection of air is generated in the airflow path.

With this configuration, the wireless communication device 210 can achieve more efficient and better heat dissipation effect compared to heat dissipation only by natural convection of air. Note that the fan 211 may be provided at any position as long as the fan 211 can form forced convection of air in the airflow path. In addition, the air inlet 203 may be disposed in such a way that the air inlet 203 faces against a direction parallel to the airflow by the fan that generates convection for cooling a communication system including the wireless communication device 210.

For example, even if the wireless communication device 210 has a configuration in which the fan 211 is provided at the air outlet 204, the wireless communication device 210 may achieve the similar effect. Furthermore, both of the air inlet 203 and the air outlet 204 may be provided with the fan 211.

In addition, depending on an environment in which the wireless communication device is located, as illustrated as a third variation in Fig. 24, the wireless communication device 220 may include, vertically above the air outlet 204, a canopy 221 spaced apart from the upper side of the enclosure unit 106 in the y-axis direction in such a way that the canopy 221 at least overlaps the opening of the air outlet 204 and does not occlude the air outlet 204 when viewed from above (viewed in the y-axis direction). With this configuration, the canopy 221 prevents rain and snow from entering the radome 205; consequently, weather resistance of the wireless communication device 220 improves. In addition, the wireless communication device 220 may include a breathable member that covers the air inlet 203 and the air outlet 204. The breathable member may be, for example, a meshed member such as a wire mesh, a cloth, or other types of members. This configuration prevents foreign objects, rain or snow from entering the radome 205; consequently, durability and weather resistance of the wireless communication device 220 can be improved.

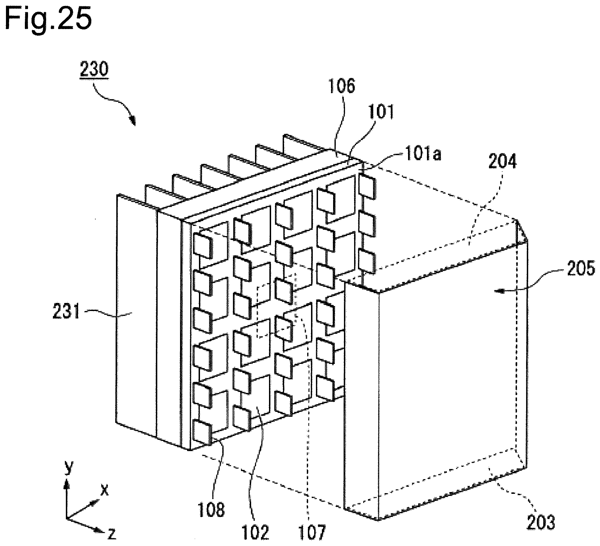

Furthermore, as illustrated as a fourth variation in Fig. 25, if the environment where the wireless communication device is located permits, the wireless communication device 230 may include a radiator 231 (heatsink) on a back side (the side opposite to the reflector surface 101a) of the enclosure unit 106. With this configuration, heat-dissipation performance of the wireless communication device 230 further improves. Note that the configuration of the radiator 231 is not limited to the one in which a plurality of radiating fins are included as in the illustrated example; a configuration in which the back side of the enclosure unit 106 is simply roughened to increase a heat-dissipating area or a configuration that utilize a phase change of the heat medium may be applied to the radiator 231.

As described above, the wireless communication device according to the second example embodiment of the present invention includes the radome with which a flow path for convection of air is formed. Therefore, outside air is efficiently supplied into the wireless communication device and consequently, the heat-dissipation performance of the wireless communication device improves.

In addition, by forming the radome using a predetermined material or including a frequency selective sheet in the radome, the wireless communication device can prevent the radome from interfering with wireless communication.

### [Third example embodiment]

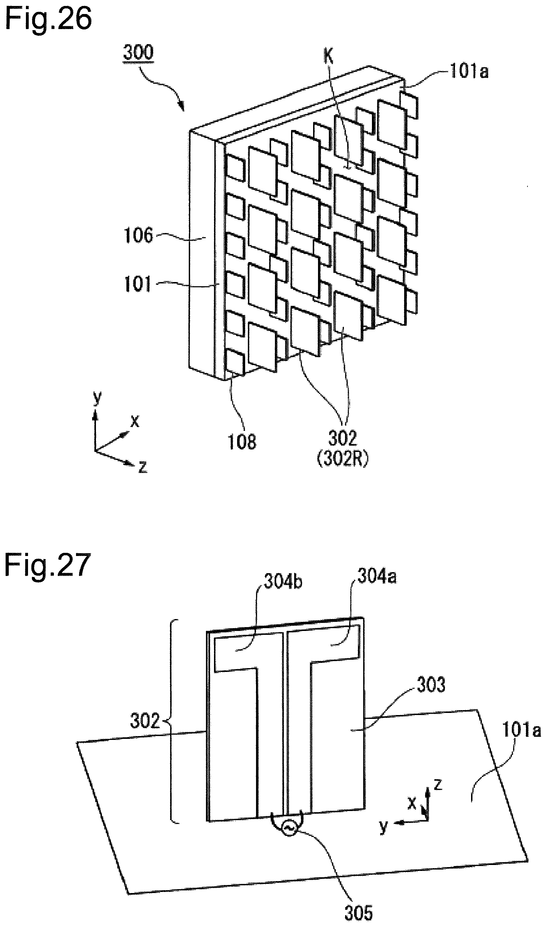

Fig. 26 is a schematic perspective view of a wireless communication device 300 according to a third example embodiment of the present invention. The wireless communication device 300 according to the third example embodiment is different from the wireless communication device 100 according to the first example embodiment in that antenna elements 302 are standing with respect to the reflector surface 101a. The same reference signs denote the components similar to those in the wireless communication device 100 according to the first example embodiment, and the detailed description thereof is not repeated.

With the antenna elements 302 standing with respect to the reflector surface 101a, both front and back surfaces of the antenna elements 302 contact air. Accordingly, heat-dissipation performance of the wireless communication device 300 improves.

As illustrated in Fig. 26, the thickness direction of the antenna elements 302 are oriented in the x-axis direction. Therefore, electromagnetic waves emitted from the antenna elements 302 enter the radiating fins 108 extending in the same direction. The radiating fin 108 includes, similarly to that of the wireless communication device 100 according to the first example embodiment, the slit 108a and the bridging conductor 108b, and can transmit an electromagnetic wave in a specific band. In other words, the wireless communication device 300 according to the third example embodiment can dissipate heat without interference with wireless communication by the radiating fins 108.

The air heated by heat dissipation travels in a vertically upward direction as density of the air decreases. When the antenna elements 302 extend, similarly to the radiating fins 108, in the y-axis direction, the wireless communication device 300 can prevent the antenna elements 302 from disturbing natural convection.

Each of the antenna elements 302 includes, as illustrated in Fig. 27, a plate-shaped dielectric substrate 303 and antenna patterns 304a and 304b, which are conductor patterns formed on a surface of the dielectric substrate 303. The dielectric substrate 303 is disposed as described above in such a way that the thickness direction thereof is oriented in the x-axis direction. The dielectric substrate 303 is formed of a printed circuit board using, for example, a glass epoxy resin, or a ceramic substrate such as an LTCC.

In the present example embodiment, on one side of the aforementioned dielectric substrate 303, a pair of generally L-shaped printed traces are provided. The printed traces are desirably formed of a material having good electrical conductivity as well as good heat conductivity such as copper foil. These printed traces are the antenna patterns 304a and 304b described above. When the antenna elements 302 having good heat conductivity is further connected with the reflector plate 101 by a material having good heat conductivity such as solder, as is the case with the radiating fins 108, the heat from the communication circuit 107 also conducts to the antenna elements 302; as a result, the heat-dissipation performance of the wireless communication device 300 can be improved.

Furthermore, the antenna patterns 304a and 304b are connected with the communication circuit 107 built into the enclosure unit 106 via a feeding point 305. The communication circuit 107 supplies electric power to the antenna patterns 304a and 304b via the feeding point 305. In this manner, the communication circuit 107 excites the antenna elements 302. As described above, the antenna element 302 forms a dipole antenna using the antenna patterns 304a and 304b.

The third example embodiment of the present invention has been described above with reference to the drawings; however, various changes may be made to the configuration described above without departing from the gist of the present invention.

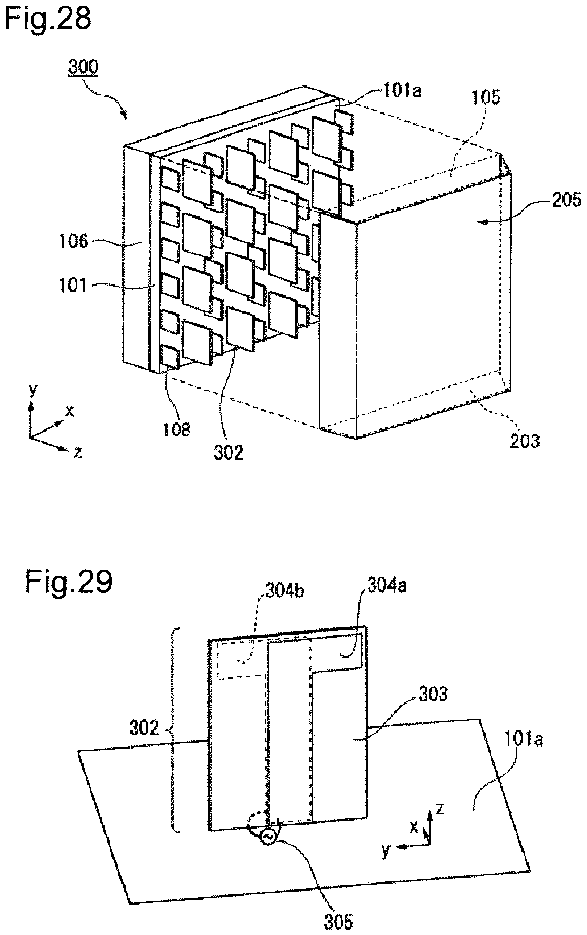

For example, as illustrated as a first variation in Fig. 28, the reflector surface 101a of the reflector plate 101 preferably includes the radome 205. By including the radome 205 in the wireless communication device 300, the wireless communication device 300 can protect the antenna elements 302 from physical impact. In addition, by including the radome 205 in the wireless communication device 300, the wireless communication device 300 can facilitate natural convection in the airflow path surrounded by the radome 205 and the reflector plate 101. Note that, since the antenna elements 302 extend in the same direction as the radiating fins 108 along the natural convection current, the antenna elements 302 do not disturb the natural convection.

Furthermore, if the environment where the wireless communication device is located permits, a radiator (heatsink) similar to the one illustrated in Fig. 25 may be provided on the back side (the side opposite to the reflector surface 101a) of the enclosure unit 106. With this configuration, the heat-dissipation performance of the wireless communication device further improves. In addition, depending on the environment where the wireless communication device is located, a canopy may be provided above an outlet hole similarly to the one in Fig. 24. With this configuration, the wireless communication device prevents rain and snow from entering the radome; consequently, weather resistance of the wireless communication device improves.

In the example embodiment described above, a case in which the antenna patterns 304a and 304b are provided on only one side of the dielectric substrate 303 has been described. However, aspects of the antenna patterns are not limited to this; as illustrated as a second variation in Fig. 29, the antenna pattern 304a may be provided on one side of the dielectric substrate 303 while the antenna pattern 304b may be provided on the other side of the dielectric substrate 303.

The antenna used for the antenna element 302 is not limited to dipole antennas illustrated in Fig. 27 and Fig. 29, and it may be an antenna using a split-ring resonator.

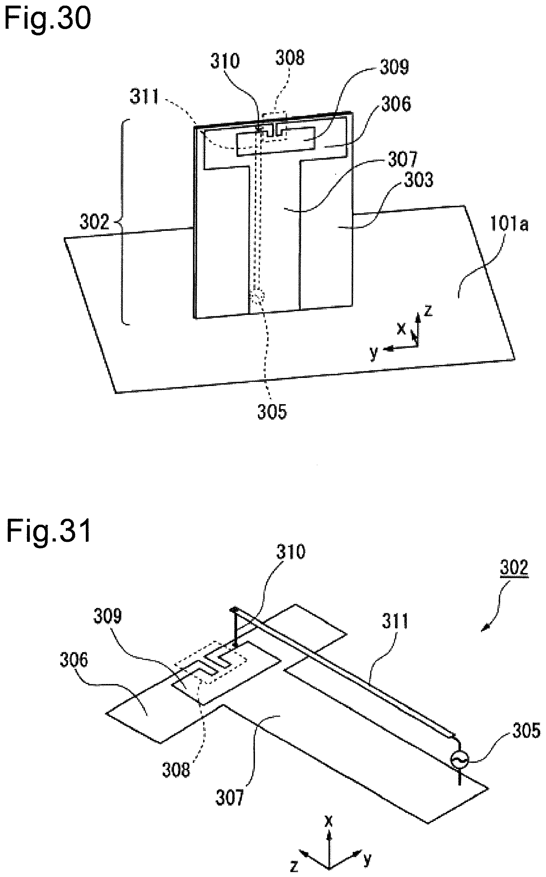

More specifically, as illustrated as a third variation in Fig. 30 and Fig. 31, the antenna element 302 has a configuration in which a generally T-shaped printed trace is formed on a surface of the dielectric substrate 303. A region of the printed trace closer to the reflector plate 101 (reflector surface 101a) is generally rectangular and constitutes a rectangular conductor portion 307. In contrast, a region distant from the reflector surface 101a is generally C-shaped and constitutes an annular conductor portion 306.

In the annular conductor portion 306, a split portion 308 is formed by cutting away a part of the annular conductor portion in a circumferential direction. In this manner, the annular conductor portion 306 serves as a coil (inductor) and generates a magnetic field in a rectangular region 309 inside while the split portion 308 serves as a capacitor and ensures a certain capacitance. With this configuration, an inductor and a capacitor are connected in series to form a split-ring resonator.

Other part of the annular conductor portion 306 in the circumferential direction is connected with a feeder wire 311 through a feeding via 310. In this manner, a wireless signal transmitted from the feeding point 305 is configured to be input to the split-ring resonator.

The antenna element 302 serving as a split-ring resonator can be reduced in size compared to a dipole antenna operating at the same operation frequency. As a result, compared to a case where the antenna element 302 serving as a dipole antenna is used, a wider gap between the antenna elements 302 may be ensured. With this configuration, the communication circuit 107 may be more efficiently cooled.

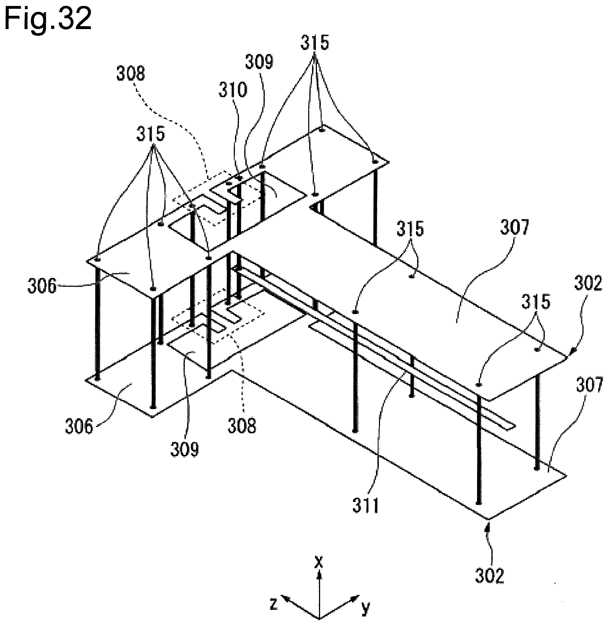

Furthermore, as illustrated as a fourth variation in Fig. 32, a plurality of antenna elements 302 serving as a dipole antenna may be stacked and connected with each other by a conductive via 315, and a feeder wire 311 may be provided between the antenna elements 302. With this configuration, the antenna elements 302 facing against each other can improve shielding performance with respect to the feeder wire 311. In other words, the feeder wire 311 may be shielded from a noise from outside.

As described above, by using the wireless device according to the third example embodiment of the present invention, an area in which the standing antenna elements contact air is increased; therefore, heat may be more efficiently dissipated. In addition, since the radiating fin has the slit 108a and the bridging conductor 108b, the radiating fin does not interfere with electromagnetic waves emitted from the antenna elements and heat can be efficiently dissipated.

### [Fourth example embodiment]

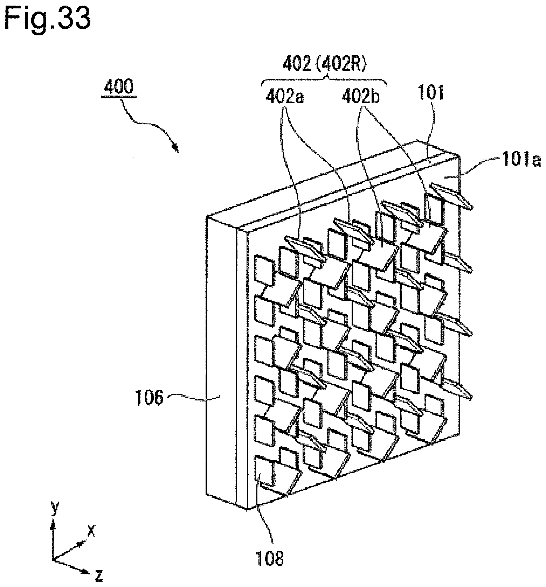

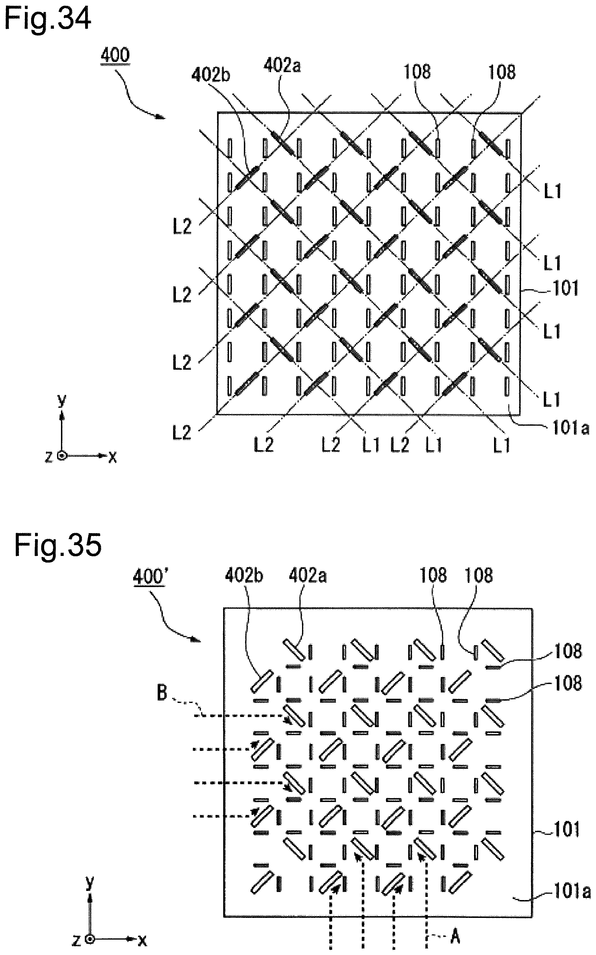

Fig. 33 is a schematic perspective view of a wireless communication device 400 according to a fourth example embodiment of the present invention. Fig. 34 is a schematic plan view of the wireless communication device 400 according to the fourth example embodiment of the present invention. The wireless communication device 400 according to the fourth example embodiment is different from the wireless communication device 300 according to the third example embodiment in that antenna elements 402 are inclined with respect to the y-axis direction. The same reference signs denote the components similar to those in the wireless communication device 100 according to the first example embodiment, and the detailed description thereof is not repeated.

The antenna elements 402 in the wireless communication device 400 includes a first element array L1 including a plurality of first antenna elements 402a and a second element array L2 including a plurality of second antenna elements 402b.

The first antenna elements 402a of the first element array L1 extend in a first direction, which is inclined at approximately 45° with respect to the y-axis direction in the y-z plane on the reflector surface 101a.

In contrast, the second antenna elements 402b of the second element array L2 are obliquely arranged in a direction (second direction) approximately orthogonal to the aforementioned first direction in the y-z plane. A plurality of first element arrays L1 are arranged on the reflector surface 101a at intervals in the second direction while a plurality of second element arrays L2 are arranged at intervals in the first direction.

A plurality of the first antenna elements 402a and a plurality of the second antenna elements 402b are individually arranged in a square grid pattern, the grids having the same lattice constant. In other words, when viewed from the normal direction (z direction) with respect to the reflector surface 101a, dimensions between the first antenna elements 402a adjacent to each other are approximately equal. Likewise, dimensions between the second antenna elements 402b adjacent to each other are approximately equal.

Each of the first antenna elements 402a is disposed between a pair of second antenna elements 402b adjacent to each other in the second direction. In addition, when viewed from the normal direction with respect to the reflector plate 101 (reflector surface 101a), a line obtained by connecting a pair of adjacent second antenna elements 402b is configured to pass the center of the first antenna element 402a in the first direction. As described above, since the second antenna elements 402b are also arranged in a square grid pattern, a line obtained by connecting a pair of adjacent first antenna elements 402a is configured to pass the center of the second antenna element 402b in the first direction. Note that the term "center" described above need not be accurate, and the lines may pass a region that divide the first antenna element 402a or the second antenna element 402b substantially equally.

As described above, since the first element array L1 and the second element array L2 are arranged in directions orthogonal to each other, their polarizations are also orthogonal to each other. In addition, a plurality of the first element arrays L1 and a plurality of the second element arrays L2 are individually controlled by the communication circuit 107 (not illustrated in Figs. 33 and 34). In other words, the first element array L1 and the second element array L2 are individually supplied with a wireless signal having a different phase and a different electric power. In this manner, the first element array L1 and the second element array L2 form array antennas independent from each other. In other words, these array antennas operate as a dual-polarized array antenna that can form a different beam for each polarization.

Furthermore, by arranging the first element arrays L1 and the second element arrays L2 as described above, it is possible to reduce a possibility of overlap between a region in which intensity of electric fields and magnetic fields formed by emission of signals from the first antenna elements 402a is strong and a region in which intensity of electric fields and magnetic fields formed by emission of signals from the second antenna elements 402b is strong.

Accordingly, while preventing electromagnetic coupling of the first antenna elements 402a and the second antenna elements 402b, the first antenna elements and the second antenna elements may be arranged adjacent to each other. In addition, with the configuration described above, gaps formed between the first antenna elements 402a and the second antenna elements 402b meander in a zig-zag manner along the y-axis direction. Accordingly, air flowing through the airflow path due to natural convection sufficiently contacts the first antenna elements 402a and the second antenna elements 402b; therefore, heat-dissipation performance of the wireless communication device 400 further improves.

### [Fifth example embodiment]

Fig. 35 to Fig. 37 illustrate a wireless communication device 400' according to a fifth example embodiment of the present invention. Fig. 35 is a schematic plan view of the fifth example embodiment, and a configuration of the wireless communication device 400' according to the fifth example embodiment is different from that of the wireless communication device 400 according to the fourth example embodiment in that in addition to radiating fins 108 parallel to the y-axis direction, radiating fins 108 parallel to the x-axis direction are included.

As illustrated in Fig. 35, by further including the radiating fins 108 parallel to the x-axis direction, the wireless communication device 400' according to the fifth example embodiment can introduce both an ascending airflow A flowing in the vertical direction (y-axis direction) and outside wind B blowing in the horizontal direction (x-axis direction) into an antenna area and discharge the airflow A and the wind B from the antenna area while not disturbing the airflow A and the wind B, and heat-dissipation performance of the wireless communication device 400' can be improved.

In particular, by obliquely arranging the first antenna elements 402a, the second antenna elements 402b, and the radiating fins 108 with which the airflow introduced into the antenna area first collides in such a way that they do not intersect with the airflow at right angles, reduction in speed of the airflow may be prevented, which is preferable in terms of improving the heat-dissipation performance.

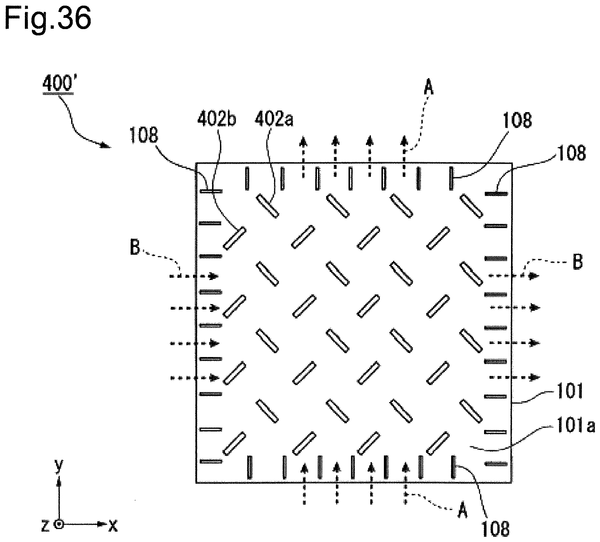

The configuration is not limited to the one illustrated in Fig. 35, and as illustrated as a first variation in Fig. 36, the radiating fins 108 may be radially arranged around outer edges of the reflector plate 101 in such a way they surround the antenna area in which the first element arrays L1 and the second element arrays L2 are disposed. With this configuration, both the ascending airflow A and the outside wind B may be introduced into the antenna area and discharged from the antenna area; consequently, the heat-dissipation performance can be improved.

The configuration is not limited to those illustrated in Fig. 35 and Fig. 36, and the arrangements of the radiating fins 108 illustrated in Fig. 35 and Fig. 36 may be used in combination. For example, in arranging the radiating fins 108, the radiating fins 108 may be partially omitted while confirming the heat-dissipation efficiency around or in the antenna area.

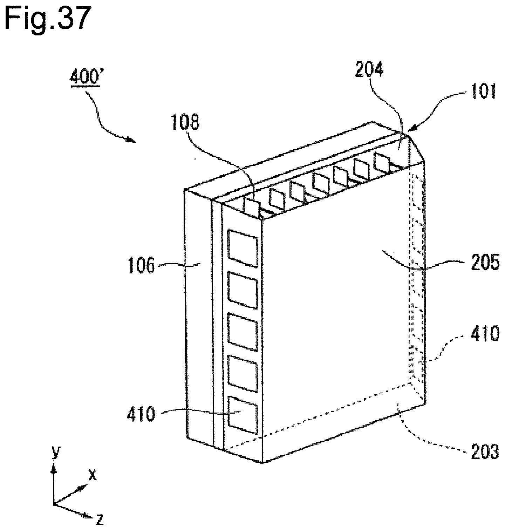

Furthermore, as illustrated as a second variation in Fig. 37, the radome 205 may be added to the configurations illustrated in Fig. 35 and Fig. 36. In this case, as illustrated in Fig. 37, an opening 410 is preferably provided on side faces of the radome 205 in addition to the air inlet 203 and the air outlet 204 in the upward and downward directions. With this configuration, while including the radome 205, it is possible to introduce wind blowing in the x-axis direction, which is a horizontal direction.

Note that, although Fig. 37 illustrates an example in which a plurality of openings 410 are provided in a region of the side faces of the radome 205, the opening 410 may be formed by removing large portions of the side faces of the radome 205 or may be configured in other ways.

In any of the configurations illustrated in Fig. 35 to Fig. 37, electromagnetic waves emitted by the antenna elements 402 enter the radiating fins 108. However, since the radiating fin 108 includes, similarly to that of the wireless communication device 100 according to the first example embodiment, the slit 108a and the bridging conductor 108b, and can transmit an electromagnetic wave in a specific band. In other words, the wireless communication devices 400 and 400' according to the fourth and fifth example embodiments can dissipate heat without interference with wireless communication by the radiating fins 108.

In the present example embodiment, the wireless communication device 400' may also utilize the radome 205, the fan 211, the canopy 221, and the radiator 231 (heatsink) similarly to the wireless communication devices described above. In addition, individual antenna elements 402 to be used may be similar to the antenna element 302 in the third example embodiment. The antenna element 302 described in the third example embodiment may be configured in such a way that it does not disturb the airflow in the airflow path by employing a small antenna by means of a split-ring resonator as illustrated in Fig. 30 to Fig. 32.

As described above, the wireless communication devices according to the fourth and fifth example embodiment can dissipate heat without interference with the electromagnetic waves emitted from the antenna elements. In addition, since the wireless communication devices include antennas obliquely extending in two directions, the wireless communication devices may form a different beam for each polarization.

The present invention has been described above with reference to the example embodiments; however, the present invention is not limited to the aforementioned example embodiments. Modifications, more particularly those in design may be made to the configurations in the present invention without departing from the gist of the present invention, for example, omissions, substitutions, or changes that could be understood by those skilled in the art within the scope of the gist of the present invention.

The present invention may be utilized in antennas and wireless communication devices including the same.

This application is based upon and claims the benefit of priority from Japanese patent application No. 2017-048693, filed on March 14, 2017, the disclosure of which is incorporated herein in its entirety by reference.

### Reference signs List

1 Reflector plate
2 Conductor fin
3 Slit portion
4 Bridging conductor portion
100, 200, 210, 220, 230, 300, 400 Wireless communication device
101 Reflector plate
101a Reflector surface
102, 302, 402 Antenna element
102R, 302R, 402R Array antenna
106 Enclosure unit
107 Communication circuit
108 Radiating fin
108a Slit
108b Bridging conductor
108c Solder (connection)
201 Top plate
202 Supporting portion
203, 503 Air inlet
204, 504 Air outlet
205, 505 Radome
205a Bottom plate
205b Top plate
211 Fan
221 Canopy
231 Radiator (heatsink)
303 Dielectric substrate
304a, 304b Antenna pattern (conductor pattern)
305 Feeding point
306 Annular conductor portion
307 Rectangular conductor portion
308 Split portion
309 Rectangular region
310 Feeding via
311 Feeder wire
315 Conductive via
402a First antenna element
402b Second antenna element
403 Opening
E Electromagnetic wave
L1 First element array
L2 Second element array

## Claims

1. A heat-dissipation mechanism, comprising:
an antenna reflector plate on which a reflector surface for reflecting an electromagnetic wave is formed; and
at least one conductor fin connected to the reflector plate crosswise, wherein
the conductor fin includes at least one slit portion that separates the conductor fin in a direction intersecting with the reflector surface, and
the slit portion includes at least one bridging conductor portion that connects portions of the conductor fin, the portions being separated across the slit portion.

2. The heat-dissipation mechanism according to claim 1, wherein
the conductor fin further includes
an additional conductor portion being distant from the bridging conductor portion and connected to a portion of an end of the conductor fin separated across the slit portion.

3. The heat-dissipation mechanism according to claim 1 or 2, wherein
the bridging conductor portion includes a meandering shape.

4. The heat-dissipation mechanism according to any one of claims 1 to 3, wherein
a distance between the slit portion closest to the reflector surface among the slit portions and the reflector surface is 1/4 or less of a wavelength in vacuum of an electromagnetic wave emitted by an antenna.

5. The heat-dissipation mechanism according to any one of claims 1 to 4, wherein
the conductor fin includes a plurality of conductor layers, and the conductor layers are connected by a conductor via.

6. A wireless communication device, comprising:
the heat-dissipation mechanism according to any one of claims 1 to 5;
one or more antennas disposed on the reflector surface; and
a transceiver circuit that is connected to the reflector plate and transmits and receives a wireless signal through the antenna.

7. The wireless communication device according to claim 6, further comprising:
a radome that is formed in such a way as to cover the antenna, and has at least one opening.

8. The wireless communication device according to claim 7, wherein
the radome includes a frequency selective sheet in which conductor portions are arranged regularly.

9. The wireless communication device according to any one of claims 6 to 8, wherein
the antenna is standing in a direction orthogonal to the reflector surface.

10. The wireless communication device according to claim 9, wherein
the antenna includes:
a first element array composed of a plurality of first antenna elements extending in a first direction; and
a second element array composed of a plurality of second antenna elements extending in a second direction orthogonal to the first direction, and
a plurality of the first element arrays are arranged at intervals in the second direction and a plurality of the second element arrays are arranged at intervals in the first direction.
